# EUROPEAN PATENT SPECIFICATION

(11) **EP 3 439 053 B1**
(45) Date of publication and mention of the grant of the patent: **11.11.2020**
(21) Application number: 17020334.3
(22) Date of filing: 04.08.2017
(51) Int. Cl.: H01L 35/32

(54) **GROUND ENERGY HARVESTING SUPPLY TERMINAL**
BODENENERGIEGEWINNENDE EINSPEISEKLEMME
BORNE D'ALIMENTATION DE COLLECTE D'ÉNERGIE DU SOL

(43) Date of publication of application: 06.02.2019
(73) Proprietor: Cerasani, Ennio, 06800 Cagnes-sur-Mer (FR)
(72) Inventor: Cerasani, Umberto, 06800 Cagnes-SUR-MER (FR); Cerasani, Luca, 06800 Cagnes-SUR-MER (FR)

(56) References cited:
- WO-A1-2012/078024
- JP-A- 2005 136 212
- US-A1- 2007 125 413
- US-B1- 7 814 965

## Description

### 1. History

Seebeck effect was discovered in 1821 by Thomas Johann Seebeck. He found that a circuit made from two dissimilar metals, with junctions at different temperatures would generate an electrical current.

Many studies **have been** conducted to use this effect for thermal energy harvesting but **conversion efficiency is limited by the actual** ZT limitation wall. Conversion efficiency is proportional to ZT = σ S²/κ which depends on the Seebeck coefficient S, thermal conductivity κ, electrical conductivity σ, and temperature T in Kelvin degrees. Another limitation is due to the fact that material with high ZT value are very expensive and often dangerous especially when used at low temperature i.e. less than 50°C. The US patent application publication US2007/0125413 A1 discloses a heatpipe associated with a thermoelectric generator which can harvest energy from the natural temperature difference between the air and the soil.

### 2. Presentation

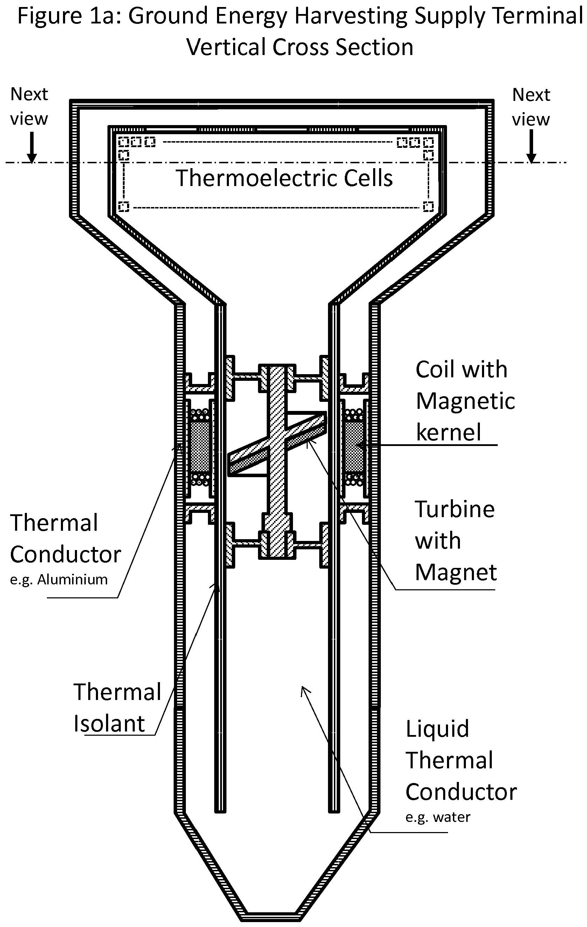

**Fig. 1a** **is a schematic top-down perspective view of the system.**

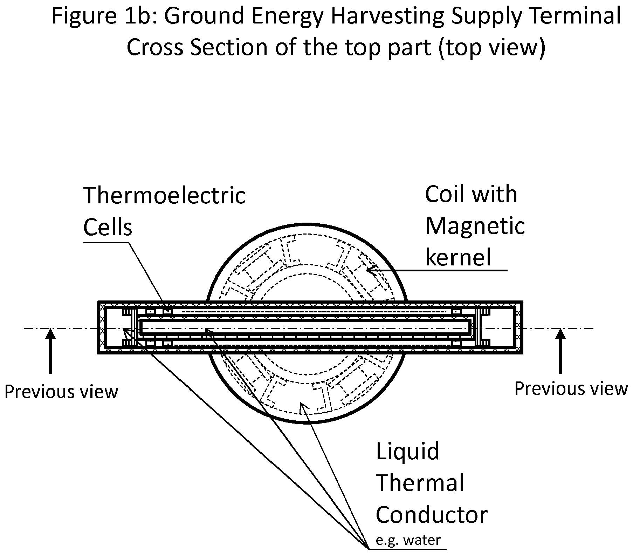

**Fig. 1b** **is a schematic cross-sectional view illustrating the main elements of the system.**

This Ground Harvesting Supply Terminal (GEH-ST), contains a Thermoelectric Generator (referenced as TEG) based on Seebeck effect.

The TEG element transforms the difference of temperature between the ground surface and deeper ground areas into electrical energy.

This Ground Harvesting Supply Terminal (GEH-ST) is based on the Seebeck effect and contains the following elements (see Figure 1) :
- A Seebeck based TEG that allows the generation of electrical energy when a temperature difference appears between one side of the system (external plate) and the other side of the system (internal plate)
- A water (or any other better liquid thermal conductor) circuit that allows the transport the liquid from the deeper part to the TEG element near the surface and vice versa
- A brushless turbine that allows the circulation of water when the external coils generate a rotating magnetic field
- The coils, which are powered by an electronic circuit, using part of the generated electrical energy from the TEG. The remaining energy can be used to power other devices.

The brushless propeller turbine also increases the lifetime of the system and decreases the maintenance cost.

This system is also capable to produce energy at lower temperature differences between the two opposite sides of the system (i.e. between ground surface and deeper ground areas) than typical TEG applications such as below 5° C .

Although this system achieves better results with high ZT TEG elements, in the preferential application, TEG elements with ZT values much less than 1 are used, since currently materials with high ZT value are very expensive and can be dangerous.

## Claims

1. An energy harvesting system, based on Seebeck effect generated by a ThermoElectric Generator (TEG), using the temperature difference between the ground surface and deeper ground area and further comprising:
- a circuit that allows the transport of a thermal conducting liquid, such as water, from the deeper part of the TEG element near the surface and vice versa, using a brushless propeller turbine.

2. The energy harvesting system described in claim 1, which can utilize ThermoElectric Generators made of cost effective and harmless materials, with low ZT values.

3. The energy harvesting system of claim 1, wherein the brushless propeller turbine can be powered directly by external coils generating a rotating magnetic field using part of the generated electrical energy from the ThemoElectric Generator (TEG).

## Patentansprüche

1. Ein Energieauffangsystem basierend auf dem Seebeck-Effekt, der mit einem thermoelektrischen Generator (TEG) erzeugt wird, wobei der Temperaturunterschied zwischen Bodenoberfläche und einer der tieferen Bodenschichten genutzt wird, und Folgendes enthält:
- Ein Kreislauf die Zirkulation einer wärmeleitenden Flüssigkeit, wie Wasser, vom tiefstgelegenen Teil des TEG-Elements hinauf zur Oberfläche und umgekehrt ermöglicht, wobei eine Propellerturbine ohne Flügel benutzt wird.

2. Das in Anspruch 1 beschriebene Energieauffangsystem, das thermoelektrische Generatoren benutzen kann, die mit kostengünstigen Materialien, ohne Gefahren und mit einem geringem ZT Koeffizienten hergestellt werden.

3. Das in Anspruch 1 beschriebene Energieauffangsystem, in welchem die Propellerturbine direkt von externen Spulen versorgt wird, die ein magnetisches Drehfeld erzeugen und einen Teil der vom thermoeletrischen Generator erzeugten Energie (TEG) benutzen.

## Revendications

1. Un système de récupération d'énergie, basé sur l'effet Seebeck induit (ou généré) par un générateur thermoélectrique (GTE ou TEG), utilisant la différence de température entre la surface du sol et une partie plus profonde du sol et comprenant :
- Un circuit qui permet la circulation (ou le transport) d'un liquide conducteur de chaleur, tel que l'eau, de la partie la plus profonde de l'élément GTE (ou TEG) vers la surface et vice versa, en utilisant une turbine à hélice sans balais.

2. Le système de récupération d'énergie décrit dans la revendication 1 (qui) peut utiliser des générateurs thermoélectriques fabriqués avec des matériaux à bas coût, sans danger, et avec un faible coefficient ZT.

3. Le système de récupération d'énergie décrit dans la revendication 1 dans lequel la turbine à hélice peut être alimentée directement par des bobines externes générant un champ magnétique tournant et utilisant une partie de l'énergie générée par le générateur thermoélectrique (GTE ou TEG).
